# EUROPEAN PATENT SPECIFICATION

(11) **EP 2 826 952 B1**
(45) Date of publication and mention of the grant of the patent: **06.01.2016**
(21) Application number: 13177166.9
(22) Date of filing: 19.07.2013
(51) Int. Cl.: E21B 41/00, H05K 7/20

(54) **Housing, power module and electrical power converter**
Gehäuse, Leistungsmodul und Stromrichter
Boîtier, module de puissance et convertisseur de puissance électrique

(43) Date of publication of application: 21.01.2015
(73) Proprietor: ABB Technology Ltd, 8050 Zürich (CH)
(72) Inventor: Spindler, Christian, 8707 Uetikon am See (CH); Duran, Hamit, 5300 Turgi (CH)
(74) Representative: Savela, Reino Aleksi

(56) References cited:
- EP-A1- 2 579 438

## Description

### TECHNICAL FIELD

The invention relates to a housing, power module and electrical power converter.

### BACKGROUND

An area of great development at the moment is subsea power electronics, such as electrical power converters. One emerging application is powering electric machinery on the seabed, e.g. used in the oil and gas exploitation industry.

In subsea, hydrostatic pressure increases with a rate of 1 bar each 10 m of water depth. One way to manage the pressure is to house the electrical power converter in a pressure adapted tank with flexible walls filled with a liquid, whereby the internal pressure assumes the surrounding water pressure at all times.

All components of the electrical power converter need to be able to withstand the high hydrostatic pressure with target values in the order of 300 bar. Since the subsea electrical power converter is provided in an inhospitable environment where frequent maintenance is costly or impossible, any improvement in reliability and/or performance would be of great benefit.

EP2579438 presents a power cell for deepwater application comprising an power cell housing, a capacitor bank, an electronic module, and input/output connectors, wherein the power cell housing is essentially made of an insulating material. The invention further describes a power cell system comprising a number of replaceable power cells, a frame for supporting the power cells, and electric connections, in particular a busbar arrangement for connecting to the power cell.

### SUMMARY

It is an object to provide a way to deploy more reliable power modules in a subsea environment.

According to a first aspect, it is provided a housing for housing at least one power semiconductor, the housing comprising: two openings and; two movable covers provided respectively by the two openings. Each movable cover is arranged to move, during operation, from an open state, in which the respective cover does not cover its respective opening, to a closed state, in which the respective cover covers its respective opening, when the respective cover is subjected to a pressure from a shockwave occurring inside the housing. The openings provide cooling of installed power semiconductors by allowing fluid to flow. Also, by letting the shockwave effect the closing of the cover, no complicated or error prone control circuitry is needed to close the covers.

Each one of the two openings may be provided in a position to interconnect with an opening of an adjacent corresponding housing. This allows the fluid to flow from one housing to the next.

Each cover may be pivotably fixed to the housing.

Each cover may be mounted on a respective collapsible cover holder.

The collapsible cover holder may comprise at least three sections respectively provided between a section of the cover and the housing.

The openings may be provided such that, during operation in the open state, the fluid cools any one or more power semiconductors provided in the housing.

The housing may further comprise at least one guiding fin to, during operation in the open state, guide the fluid past the one or more power semiconductors provided in the housing.

The housing may further comprise a holding device for preventing the cover from opening when in the closed state.

The holding device may be a snap lock.

According to a second aspect, a power module comprising the housing according to the first aspect is provided and at least one power semiconductor provided in the housing.

The power module may further comprise, for each power semiconductor, a spring and an electrical current bypass connector, wherein the electrical current bypass connectors are aligned.

The electrical current bypass connectors may be aligned to, during operation in the open state, guide fluid past any installed power semiconductors.

According to a third aspect, it is provided an electrical power converter comprising a plurality of power modules according to the second aspect.

It is to be noted that any feature of the first, second and third aspects may, where appropriate, be applied to any other of these aspects.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated.

### BRIEF DESCRIPTION OF THE DRAWINGS

The invention is now described, by way of example, with reference to the accompanying drawings, in which:
Fig 1 is a schematic diagram illustrating an electric power converter in a subsea environment;
Figs 2A-B are schematic diagrams illustrating an embodiment of any one of the power modules of the electric power converter of Fig 1;
Figs 3A-B are schematic diagrams illustrating the opening of a housing and corresponding cover of the power module of Figs 2A-B according to one embodiment;
Fig 4 is a schematic diagram illustrating the cover of Figs 3A-B in a view perpendicular to the cover;
Figs 5A-B are schematic diagrams illustrating the opening of a housing and corresponding cover of the power module of Figs 2A-B according to one embodiment;
Fig 6 is a schematic diagram illustrating the interconnection of power modules of Figs 2A-B according to one embodiment;
Figs 7A-C are schematic diagrams illustrating an embodiment of a sub-module 5 of Fig 2A-B according to one embodiment; and
Fig 8 is a schematic diagram illustrating the power module of Figs 2A-B according to one embodiment.

### DETAILED DESCRIPTION

The invention will now be described more fully hereinafter with reference to the accompanying drawings, in which certain embodiments of the invention are shown. This invention may, however, be embodied in many different forms and should not be construed as limited to the embodiments set forth herein; rather, these embodiments are provided by way of example so that this disclosure will be thorough and complete, and will fully convey the scope of the invention to those skilled in the art. Like numbers refer to like elements throughout the description.

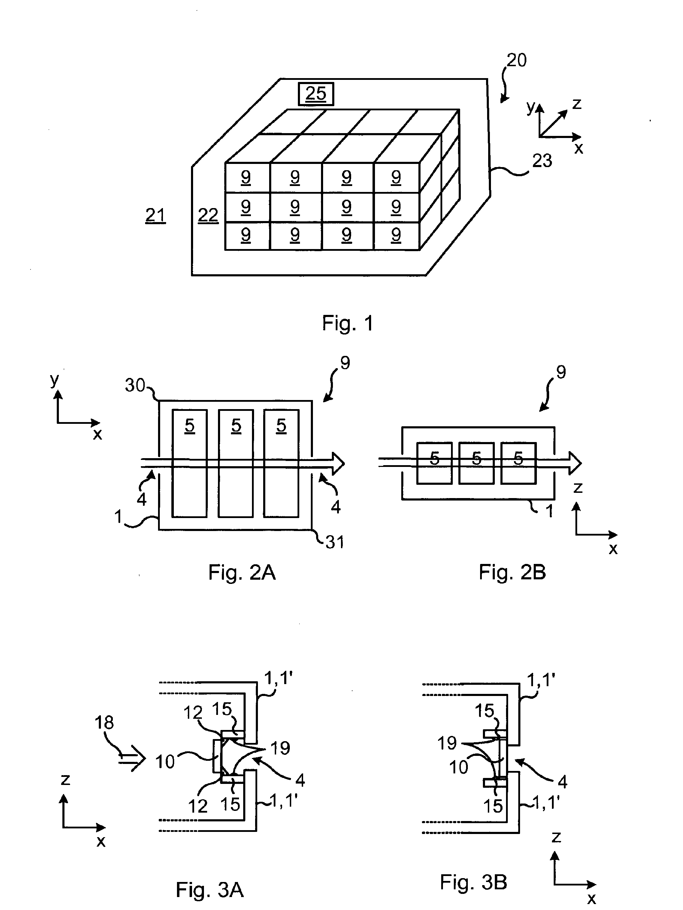

Fig 1 is a schematic diagram illustrating an electric power converter in a subsea environment. Here, an electric power converter 20 is shown in a container 23, separating the electric power converter 20 from the surrounding environment 21, i.e. sea water at subsea pressure. Within the thin container 23, a fluid 22 is provided. The fluid 22 is any suitable dielectric fluid such as a mineral oil, silicone oil, or natural or synthetic esters.

The electric power converter 20 comprises a plurality of power modules 9, here schematically shown extending in three dimensions x, y, z in a Cartesian coordinate system. In one embodiment, the power modules 9 are stackable to achieve a serial connection in the y direction, whereby the electrical current flows in the y direction. In the x and z directions, additional power modules 9 are optionally provided to achieve a parallel connection of power modules 9. As is explained in more detail below, each power module comprises one or more controllable power semiconductors. The power converter 20 also comprises a controller 25 to control the operation of the power semiconductors of the power modules 9. In this way, the electrical power converter 20 can be controlled to operate as e.g. a DC/AC (Direct Current/Alternating Current) converter (in either direction) a DC/DC converter or an AC/AC converter. For example, the electrical power converter 20 can be used to power electrical machinery in the vicinity of the electrical power converter 20, e.g. on a seabed. In one embodiment, the electrical power converter can be operated at hydrostatic pressure at least 300 bar (equivalent to a depth of about 3 000 metres).

Figs 2A-B are schematic diagrams illustrating an embodiment of any one of the power modules of the electric power converter of Fig 1, here represented by a single power module 9.

The power module 9 comprises a housing 1 which encompasses one or more sub-modules 5 comprising one or more power semiconductors, arranged in parallel between a top end 30 and a bottom end 31. The electrical current flows in the y direction. The housing 1 comprises two openings 4 arranged at either side of the power module 4 in the x direction, i.e. perpendicular to the direction of the electrical current flow. It is to be noted that the housing 1 can be provided with more openings, as long as there are at least two openings, allowing the fluid to flow through the power module 9. Moreover, the openings 4 can be provided in other positions of the power module 9 to allow fluid to flow in any suitable direction, as long as the fluid flows through the power module 9.

In this way, the fluid around the power module 9 can flow through the power module 9 and cool the sub-modules 5 and therein contained power semiconductors. In the prior art, there is no way for a fluid to circulate through the power module and instead, the power module is cooled using heat sinks on the top end 30 and/or bottom end 31. Using also the fluid for cooling is a significantly more efficient cooling mechanism compared to the prior art, since the cooling fluid can pass by, and in contact with, the sub-modules 5 and, depending on the design of the sub-modules 5, even pass by, and in contact with, the contained power semiconductors.

The power module 9 falls into a stable short circuit failure mode in case of a fault condition, e.g. by an alloy melting due to the heat of the failure, creating a stable shortcut through the power module. This makes the power module 9 a good candidate for the MMC (modular multilevel converter) topology. In this topology an electric power converter comprises a serial connection of power modules, comprising a number of redundant power modules, i.e. there are more serially connected power modules than what is strictly necessary. In this way, if a power module fails and falls into a short circuit failure mode, the electrical power converter can still function normally by suitable control of the remaining, functional power modules. As long as there are not more failed power modules than the number of redundant power modules, the power converter can still operate normally. This provides high reliability and hence long service and maintenance intervals, which is of particular value for subsea applications.

However, when a power module 9 fails, the module 9 should be closed to the environment in order to confine damage. For example, a failed power module can lead to an explosion of the power semiconductor e.g. due to an instable short-current failure mode, which can contaminate the fluid with debris, potentially causing electrical shortcuts and/or degradation of fluid circulation. Moreover, since the dielectric liquid is, compared to air, hardly compressible, a shockwave occurring at a failure of a power module can damage components in the vicinity. To reduce the risk of such effects of a failed power module, the openings are provided with covers as shown e.g. in Figs 3A-B, 4 and 5A-B.

Figs 3A-B are schematic diagrams illustrating the opening 4 of a housing 1 of a power module 9 and/or a housing 1' of a sub-module and corresponding cover 10 of the power module according to one embodiment. Fig 3A illustrates an open state and Fig 3B illustrates a closed state. While only one cover 10 is shown in Fig 3A and 3B, all openings 4 of a power module and/or sub-module are provided with a cover.

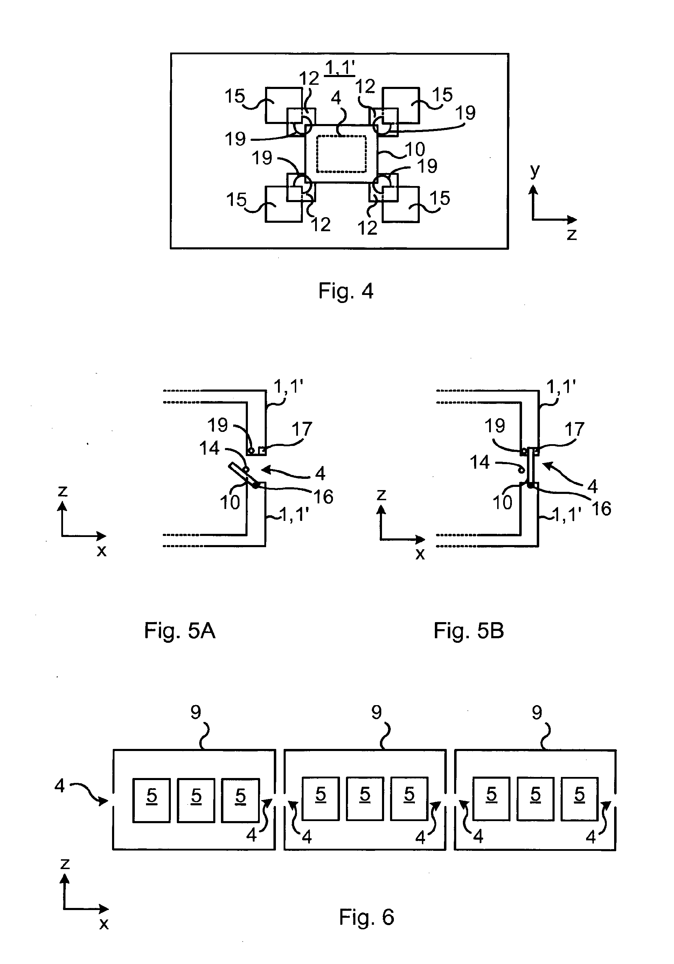

In Fig 3A, the cover 10 is mounted on a collapsible cover holder 12. The cover 10 may be kept in place by pins or by being attached to the collapsible cover holder 12. There may optionally also be a fixed holder section 15 keeping the collapsible cover holder 12 in place. The collapsible cover holder 12 and the fixed holder section 15, when present, are not solid, whereby, in the open state, the fluid can enter or exit through the opening 4 (which is seen better in Fig 4). Optionally, there are holder devices 19 which are arranged to keep the cover 10 in place during the closed state. The holder devices 19 can e.g. be pins of a resilient material implementing a snap lock.

When a power module containing the housing 1, 1' fails, there is a shockwave which results in a pressure inside the housing 1, applying a force 18 on the cover 10. The force is strong enough to break the collapsible cover holders 12, whereby the cover 10 is pushed to move towards the opening 4, past the optional holder devices 19, resulting in a closed state as shown in Fig 3B, in which the cover 10 covers the opening 4, preventing the fluid from entering or exiting through the opening 4. The optional holder devices 19 prevent the cover from moving away from the opening 4 once the cover is in the closed state.

The cover 10 is thus passively controlled, i.e. without any sensor and or active control mechanism, to go from an open state to a closed state when a power module fails, e.g. by explosion.

Fig 4 is a schematic diagram illustrating the cover of Figs 3A-B in a view perpendicular to a face the cover 10. Here, the cover 10 is rectangular. However, the cover 10 can be of any suitable shape as long as it provides a good seal to the housing 1, 1' in the closed state to prevent fluid from entering or exiting through the opening 4.

There are four sections of the collapsible cover holder 12 to hold the cover 10 in place when in the open state. As can be seen, the fluid can pass between the sections of the cover holder, and between corresponding sections of a fixed holder section 15 to enter or exit through the opening 4. In fact, when the cover 10 is of an essentially planar structure, it is sufficient if there are at least three sections respectively provided between a section of the cover and the housing 1, 1'.

The optional holder devices 19 are also shown here, overlapping at least part of the cover 10. The holder devices 19 and/or the cover 10 have sufficient flexibility such that when a shockwave occurs, it is able to force the cover 10 past the holder devices 19, forming a snap lock for the cover.

Figs 5A-B are schematic diagrams illustrating the opening of a housing 1, 1' and corresponding cover of the power module and/or a housing 1' of a sub-module according to one embodiment. Fig 5A illustrates an open state and Fig 5B illustrates a closed state. While only one cover 10 is shown in Fig 5A and 5B, all openings 4 of a power module and/or sub-module are provided with a cover, either of the same type or of a different type.

In Fig 5A, the cover 10 is in an open state. The cover 10 is pivotably fixed to the housing 1, e.g. by securing one end of the cover 10 with a pin 16 to the housing 1. An optional retainer device 14 retains the cover 10 in the open state in normal operation. The retainer device 14 can e.g. be a pin of a resilient material such that the cover can pivot past the retainer device 14 if and when it is subjected to sufficient force, e.g. by a shockwave.

When a power module containing the housing 1, 1' fails, there is a shockwave which results in a pressure inside the housing 1, subjecting a force 18 on the cover 10. The force is strong enough to move the cover towards a support 17 by the opening 4, resulting in a closed state as shown in Fig 3B, in which the cover 10 covers the opening 4, preventing the fluid from entering or exiting through the opening 4. Optionally, there is a holder device 19 which is arranged to keep the cover 10 in place during the closed state. The holder device 19 can e.g. be a pin of a resilient material extending slightly in the y direction to implement a snap lock.

The cover 10 is thus passively controlled, i.e. without any sensor and or active control mechanism, to go from an open state to a closed state when a power module fails.

Fig 6 is a schematic diagram illustrating the interconnection of power modules of Figs 2A-B according to one embodiment. It is here seen how the opening of the housing of one power module is provided in a position to interconnect with an opening 4 of an adjacent corresponding housing. In this way, the fluid can flow through several power modules 9, and potentially release its heat at a common heat exchanger (not shown), providing an efficient circulation of fluid which cools the power modules. The circulation of fluid can occur simply by convection or optionally using a pump (not shown).

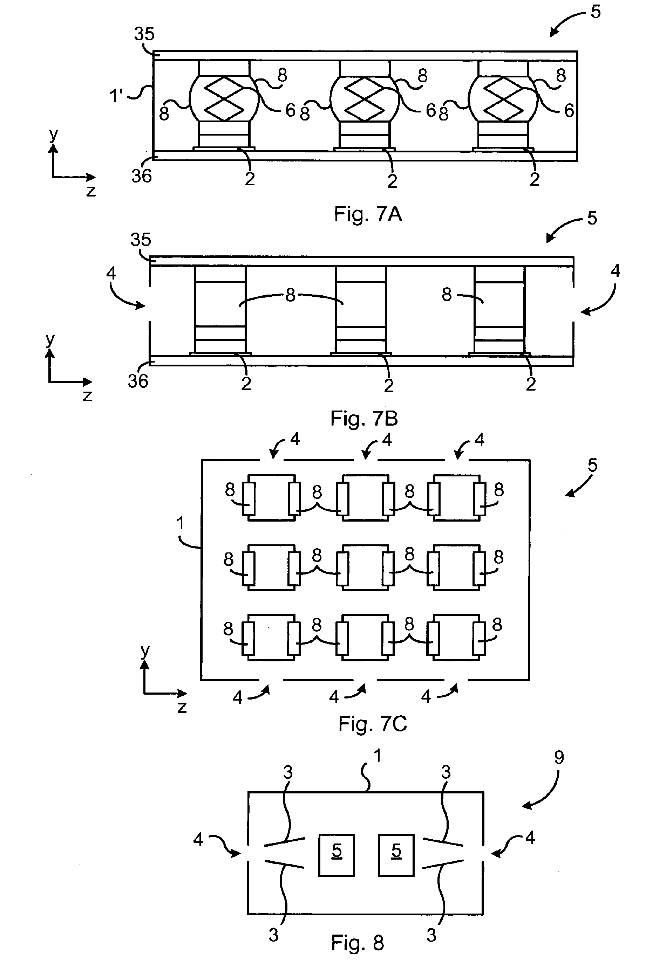

Figs 7A-C are schematic diagrams illustrating an embodiment of a sub-module 5 of Fig 2A-B according to one embodiment. The sub-module 5 comprises a housing 1' encompassing nine semiconductor sets. Each semiconductor set comprises a power semiconductor 2, a spring 6, and two electrical current bypass connectors 8, provided between a top end 35 and bottom end 36. Optionally, there may be only one electrical bypass connector 8. The power semiconductor 2 can be any suitable power semiconductor, e.g. an Insulated Gate Bipolar Transistor (IGBT), a power Field Effect Transistor (FET), a diode etc. The spring 6 is provided in a vertical direction y, providing a secure pressure between power modules containing sub-modules 5 provided in the y-direction to ensure a proper electrical connection between the power modules. The housing 1' is sufficiently flexible on the sides to allow the spring 6 to compress to even out pressure between sub-modules 5 when necessary. The current bypass connectors 8 are flexible for movement in the y-direction and provide an electrical connection between the power semiconductor 2 and the top section of the sub-module 5. As seen in Fig 7B, the current bypass connectors 8 are flat connectors, optionally provided with a convex curvature to provide predictable movement when the spring 6 is compressed.

The housing 1' is provided with openings and covers, e.g. as shown in Figs 3A-B, 4, 5A-5B above. The openings 4 are provided such that the fluid can pass in the x-direction, and thus not be blocked or inhibited by the flat current bypass connectors 8, as also seen in Fig 7C. Also, the current bypass connectors 8 operate to guide fluid past the power semiconductor 2 to thereby improve cooling. Any suitable number of openings 4 can be provided. In this embodiment, there are three openings 4 on either side in the x direction. While the sub-module 5 is here shown containing nine sets semiconductor sets, any the sub-module may be provided with any suitable number of semiconductor sets.

Optionally, the sub-module 5 is provided without a housing 1'.

When mounted in a power module 9 with a plurality of the sub-modules, the electrical current bypass connectors are aligned such that the fluid passes through the sub-modules with less resistance.

Fig 8 is a schematic diagram illustrating the power module of Figs 2A-B according to one embodiment. Here, guiding fins 3 are provided to, during operation in the open state, guide the fluid past the sub-modules 5, and thereby the contained power semiconductors.

The invention has mainly been described above with reference to a few embodiments. However, as is readily appreciated by a person skilled in the art, other embodiments than the ones disclosed above are equally possible within the scope of the invention, as defined by the appended patent claims.

## Claims

1. A housing (1, 1') for housing at least one power semiconductor (2), the housing comprising:
two openings (4) and;
two movable covers (10) provided respectively by the two openings (4),
wherein each movable cover (10) is arranged to move, during operation, from an open state, in which the respective cover does not cover its respective opening (4), to a closed state, in which the respective cover covers its respective opening, when the respective cover (10) is subjected to a pressure from a shockwave occurring inside the housing (1, 1').

2. The housing (1, 1') according to any one of the preceding claims, wherein each cover (10) is pivotably fixed to the housing (1, 1').

3. The housing (1, 1') according to claim 1, wherein each cover is mounted on a respective collapsible cover holder (12).

4. The housing (1, 1') according to claim 3, wherein the collapsible cover holder (12) comprises at least three sections respectively provided between a section of the cover and the housing (1, 1'), which sections (15) hold the cover (10) in place when in the open state.

5. The housing (1, 1') according to any one of the preceding claims, wherein the openings are provided such that, during operation in the open state, the fluid cools any one or more power semiconductors (2) provided in the housing.

6. The housing (1, 1') according to claim 5, further comprising at least one guiding fin (3) to, during operation in the open state, guide the fluid by the one or more power semiconductors (2) provided in the housing.

7. The housing (1, 1') according to any one of the preceding claims, further comprising a holding device (19) for preventing the cover from opening when in the closed state.

8. The housing (1, 1') according to claim 7, wherein the holding device is a snap lock.

9. A power module (9) comprising the housing (1, 1') according to any one of claims 1 to 7 and at least one power semiconductor (2) provided in the housing (1, 1').

10. The power module (9) according to claim 9, further comprising, for each power semiconductor (2), a spring (6) and an electrical current bypass connector (8), wherein the electrical current bypass connectors are aligned.

11. The power module (9) according to claim 10, wherein the electrical current bypass connectors (8) are aligned to, during operation in the open state, guide fluid past any installed power semiconductors (2).

12. An electrical power converter (20) comprising a plurality of power modules (9) according to any one of claims 9 to 11.

## Patentansprüche

1. Gehäuse (1, 1') zum Aufnehmen mindestens eines Leistungshalbleiters (2), wobei das Gehäuse Folgendes umfasst:
zwei Öffnungen (4); und
zwei bewegliche Abdeckungen (10), die jeweils durch die beiden Öffnungen (4) bereitgestellt werden,
wobei jede bewegliche Abdeckung (10) ausgelegt ist, sich während des Betriebs von einem offenen Zustand, in dem die jeweilige Abdeckung ihre entsprechende Öffnung (4) nicht bedeckt, in einen geschlossenen Zustand, in dem die jeweilige Abdeckung ihre entsprechende Öffnung bedeckt, zu bewegen, wenn die jeweilige Abdeckung (10) einem Druck von einer Erschütterungswelle, die innerhalb des Gehäuses (1, 1') auftritt, ausgesetzt ist.

2. Gehäuse (1, 1') nach einem der vorhergehenden Ansprüche, wobei jede Abdeckung (10) schwenkbar an dem Gehäuse (1, 1') befestigt ist.

3. Gehäuse (1, 1') nach Anspruch 1, wobei jede Abdeckung auf einem entsprechenden zusammenklappbaren Abdeckungshalter (12) befestigt ist.

4. Gehäuse (1, 1') nach Anspruch 3, wobei der zusammenklappbare Abdeckungshalter (12) mindestens drei Abschnitte umfasst, die jeweils zwischen einem Abschnitt der Abdeckung und dem Gehäuse (1, 1') vorgesehen sind, wobei die Abschnitte (15) die Abdeckung (10) am Platz halten, wenn sie in dem offenen Zustand ist.

5. Gehäuse (1, 1') nach einem der vorhergehenden Ansprüche, wobei die Öffnungen derart vorgesehen sind, dass während des Betriebs in dem offenen Zustand das Fluid einen oder mehrere Leistungshalbleiter (2), die in dem Gehäuse vorgesehen sind, kühlt.

6. Gehäuse (1, 1') nach Anspruch 5, das ferner mindestens eine Führungsfinne (3) umfasst, um während des Betriebs in dem offenen Zustand das Fluid durch den einen oder die mehreren Leistungshalbleiter (2), die in dem Gehäuse vorgesehen sind, zu führen.

7. Gehäuse (1, 1') nach einem der vorhergehenden Ansprüche, das ferner eine Haltevorrichtung (19) zum Verhindern, dass sich die Abdeckung öffnet, wenn sie in dem geschlossenen Zustand ist, umfasst.

8. Gehäuse (1, 1') nach Anspruch 7, wobei die Haltevorrichtung ein Schnappverschluss ist.

9. Leistungsmodul (9), das das Gehäuse (1, 1') nach einem der Ansprüche 1 bis 7 und mindestens einen Leistungshalbleiter (2), der in dem Gehäuse (1, 1') vorgesehen ist, umfasst.

10. Leistungsmodul (9) nach Anspruch 9, das ferner für jeden Leistungshalbleiter (2) eine Feder (6) und einen elektrischen Stromumleitungsverbindungsstecker (8) umfasst, wobei die elektrischen Stromumleitungsverbindungsstecker ausgerichtet sind.

11. Leistungsmodul (9) nach Anspruch 10, wobei die elektrischen Stromumleitungsverbindungsstecker (8) ausgerichtet sind, das Fluid während eines Betriebs in dem offenen Zustand durch alle eingebauten Leistungshalbleiter (2) zu führen.

12. Elektrischer Leistungsumsetzer (20), der mehrere Leistungsmodule (9) nach einem der Ansprüche 9 bis 11 umfasst.

## Revendications

1. Boîtier (1, 1') destiné à loger au moins un semiconducteur (2) de puissance, le boîtier comportant :
deux ouvertures (4) ; et
deux couvercles mobiles (10) placés respectivement devant les deux ouvertures (4), chaque couvercle mobile (10) étant disposé pour passer, en cours de fonctionnement,
d'un état ouvert, dans lequel le couvercle considéré ne recouvre pas son ouverture respective (4), à un état fermé, dans lequel le couvercle considéré recouvre son ouverture respective, lorsque le couvercle considéré (10) est soumis à une pression issue d'une onde de choc se produisant à l'intérieur du boîtier (1, 1').

2. Boîtier (1, 1') selon l'une quelconque des revendications précédentes, chaque couvercle (10) étant fixé de façon pivotante au boîtier (1, 1').

3. Boîtier (1, 1') selon la revendication 1, chaque couvercle étant monté sur un support escamotable (12) respectif de couvercle.

4. Boîtier (1, 1') selon la revendication 3, le support escamotable (12) de couvercle comportant au moins trois sections placées respectivement entre une section du couvercle et le boîtier (1, 1'), lesdites sections (15) maintenant le couvercle (10) en place lorsqu'il est à l'état ouvert.

5. Boîtier (1, 1') selon l'une quelconque des revendications précédentes, les ouvertures étant réalisées de telle sorte qu'en cours de fonctionnement à l'état ouvert, le fluide refroidisse un ou plusieurs semiconducteurs (2) de puissance éventuels placés dans le boîtier.

6. Boîtier (1, 1') selon la revendication 5, comportant en outre au moins une ailette (3) de guidage servant, en cours de fonctionnement à l'état ouvert, à guider le fluide devant le ou les semiconducteurs (2) de puissance placés dans le boîtier.

7. Boîtier (1, 1') selon l'une quelconque des revendications précédentes, comportant en outre un dispositif (19) de maintien destiné à empêcher le couvercle de s'ouvrir lorsqu'il est à l'état fermé.

8. Boîtier (1, 1') selon la revendication 7, le dispositif de maintien étant un encliquetage.

9. Module (9) de puissance comportant le boîtier (1, 1') selon l'une quelconque des revendications 1 à 7 et au moins un semiconducteur (2) de puissance placé dans le boîtier (1, 1').

10. Module (9) de puissance selon la revendication 9, comportant en outre, pour chaque semiconducteur (2) de puissance, un ressort (6) et un connecteur (8) de pontage de courant électrique, les connecteurs de pontage de courant électrique étant alignés.

11. Module (9) de puissance selon la revendication 10, les connecteurs (8) de pontage de courant électrique étant alignés pour, en cours de fonctionnement à l'état ouvert, guider un fluide le long d'éventuels semiconducteurs (2) de puissance installés.

12. Convertisseur (20) de puissance électrique comportant une pluralité de modules (9) de puissance selon l'une quelconque des revendications 9 à 11.
